# EUROPEAN PATENT SPECIFICATION

(11) **EP 4 050 787 B1**
(45) Date of publication and mention of the grant of the patent: **18.06.2025**
(21) Application number: 21218113.5
(22) Date of filing: 29.12.2021
(51) Int. Cl.: H02M 7/00, H02G 5/00, H05K 7/14, H01R 9/24

(54) **POWER CONVERTER**
STROMWANDLER
CONVERTISSEUR DE PUISSANCE

(30) Priority: 25.02.2021 JP 2021029147
(43) Date of publication of application: 31.08.2022
(73) Proprietor: Fuji Electric Co., Ltd., Kawasaki-shi, Kanagawa 210-9530 (JP)
(72) Inventor: YAMAZAWA, Kotaro, Kawasaki-shi, Kanagawa, 210-9530 (JP); NAKATA, Toshiyuki, Kawasaki-shi, Kanagawa, 210-9530 (JP); SAGA, Ayako, Kawasaki-shi, Kanagawa, 210-9530 (JP); URUMA, Tomoki, Kawasaki-shi, Kanagawa, 210-9530 (JP)
(74) Representative: Appelt, Christian W.

(56) References cited:
- WO-A1-2017/163828
- DE-U1- 20 120 690
- JP-A- 2009 148 011
- US-A1- 2012 305 283
- US-A1- 2017 353 118
- US-A1- 2018 317 334
- US-A1- 2020 060 022

## Description

### BACKGROUND OF THE INVENTION

### Field of the Invention

The present invention relates to a power converter, and more particularly, it relates to a power converter including a terminal block that is arranged above a circuit board and to which wiring is connected from outside the power converter, and a bus bar connected to the terminal block.

### Description of the Background Art

A power converter including a terminal block that is arranged above a circuit board and to which wiring is connected from outside the power converter, and a bus bar connected to the terminal block is known in general, as disclosed in Japanese Patent Laid-Open No. 2017-077087, for example.

Japanese Patent Laid-Open No. 2017-077087 discloses a power converter including a terminal block that is arranged above a circuit board and to which wiring is connected from outside the power converter and a bus bar connected to the terminal block. In this power converter, a semiconductor module containing a power conversion semiconductor element is connected (mounted) to the circuit board.

Although not clearly described in Japanese Patent Laid-Open No. 2017-077087, in a conventional power converter as described in Japanese Patent Laid-Open No. 2017-077087, the terminal block and the circuit board may be connected by a plurality of bus bars. In such a case, when a space over a surface of the circuit board in which the plurality of bus bars can be routed is narrow, the plurality of bus bars are spaced apart from each other in an upward-downward direction in order to prevent short circuits between the plurality of bus bars.

However, when the plurality of bus bars are spaced apart from each other in the upward-downward direction, it is necessary to space the bus bars apart from each other in the upward-downward direction by an air insulation distance (insulation distance in a case in which insulation is provided by air) in order to prevent short circuits between the plurality of bus bars, and the size of the power converter in the upward-downward direction disadvantageously increases over the circuit board. There is a method for reducing a distance between bus bars in an upward-downward direction by sandwiching an insulating member as a separate member between the bus bars and attaching the bus bars, but such a method increases the number of components and complicates assembly such that workability during assembly is decreased. Therefore, there is a demand for a power converter capable of significantly reducing or preventing an increase in the size of the power converter in an upward-downward direction while significantly reducing or preventing a decrease in workability during assembly.

US 2017/353118 A1 discloses a power conversion device including a power semiconductor module that converts a DC current into an AC current, a plate conductor that transfers the DC current or the AC current, a resin sealing material that seals the plate conductor and an electric component that is used to control the power semiconductor module, wherein the resin sealing material includes a supporting member that supports the electric component, and wherein the plate conductor is buried in a portion of the resin sealing material that is disposed to face the electric component.

### SUMMARY OF THE INVENTION

The present invention has been proposed in order to solve the aforementioned problems, and an object of the present invention is to provide a power converter capable of significantly reducing or preventing an increase in the size of the power converter in an upward-downward direction while significantly reducing or preventing a decrease in workability during assembly.

The invention is defined by the features of claim 1. The dependent claims recite advantageous embodiments of the invention.

In order to attain the aforementioned object, a power converter according to an aspect of the present invention includes a main circuit board configured to allow a power conversion semiconductor module to be mounted thereon, a terminal block arranged above the main circuit board, the terminal block being configured to allow wiring to be connected thereto from outside the power converter, and a resin molded bus bar integrally resin molded such that a plate-shaped first bus bar and a plate-shaped second bus bar, both of which are connected to the terminal block and are electrically connected to the main circuit board or the power conversion semiconductor module, are insulated by an insulating resin. The resin molded bus bar has an L-shape including a lateral portion configured to extend along the main circuit board and a vertical portion configured to extend upward from the lateral portion toward the terminal block.

In the aforementioned power converter according to this aspect, as described above, the resin molded bus bar has an L-shape including the lateral portion that extends along the main circuit board and the vertical portion that extends upward from the lateral portion toward the terminal block. Furthermore, the resin molded bus bar is integrally resin molded such that the first bus bar and the second bus bar are insulated by the insulating resin. Accordingly, the insulating resin insulates the first bus bar from the second bus bar, and thus even when the first bus bar and the second bus bar overlap in an upward-downward direction, a distance between the first bus bar and the second bus bar can be smaller in the lateral portion that extends along the main circuit board than that in a case in which insulation is provided by air (air insulation is provided). Consequently, an increase in the size of the power converter in the upward-downward direction over the main circuit board can be significantly reduced or prevented. Furthermore, the lateral portion of the resin molded bus bar including a single member in which the first bus bar, the second bus bar, and the insulating resin are integrally resin molded extends along the main circuit board such that both the first bus bar and the second bus bar can be easily electrically connected to the main circuit board or the power conversion semiconductor module. Furthermore, the vertical portion of the resin molded bus bar including a single member in which the first bus bar, the second bus bar, and the insulating resin are integrally resin molded extends from the lateral portion upward toward the terminal block such that both the first bus bar and the second bus bar can be easily electrically connected to the terminal block arranged above the main circuit board. Accordingly, both the first bus bar and the second bus bar can be easily electrically connected to the main circuit board or the power conversion semiconductor module and the terminal block arranged above the main circuit board by the resin molded bus bar as a single member having an L-shape including the lateral portion and the vertical portion. Consequently, unlike a case in which the first bus bar and the second bus bar are attached so as to sandwich an insulating member as a separate member, an increase in the number of components and complication of assembly can be significantly reduced or prevented. Thus, an increase in the size of the power converter in the upward-downward direction can be significantly reduced or prevented while a decrease in workability during assembly is significantly reduced or prevented.

In the aforementioned power converter according to this aspect, the resin molded bus bar is preferably configured to sandwich the insulating resin between the first bus bar and the second bus bar, and the first bus bar and the second bus bar are preferably stacked while being spaced apart from each other by a first separation distance that is smaller than an air insulation distance. Accordingly, even when the first bus bar and the second bus bar overlap in the upward-downward direction, the insulating resin is sandwiched between the first bus bar and the second bus bar, and thus the first bus bar and the second bus bar can be reliably insulated. Consequently, the distance between the first bus bar and the second bus bar can be smaller than the air insulation distance, and thus an increase in the size of the power converter in the upward-downward direction over the main circuit board can be significantly reduced or prevented.

In the aforementioned configuration in which the first bus bar and the second bus bar are stacked while being spaced apart from each other by the first separation distance that is smaller than the air insulation distance, the terminal block preferably includes a DC terminal block, the first bus bar preferably includes a positive electrode connector exposed from the insulating resin, the positive electrode connector being connected to a positive electrode terminal of the DC terminal block, the second bus bar preferably includes a negative electrode connector exposed from the insulating resin, the negative electrode connector being connected to a negative electrode terminal of the DC terminal block, and the first bus bar and the second bus bar are preferably configured to allow currents to flow therethrough in opposite directions to each other. Accordingly, currents flow through the first bus bar and the second bus bar in the opposite directions such that magnetic fields generated by the currents flowing through the first bus bar and the second bus bar can cancel each other out. Consequently, the inductances of the first bus bar and the second bus bar can be reduced.

In this case, the power converter preferably further includes a power supply board arranged above the main circuit board, the power supply board being configured to allow an electronic component configured to generate a control power supply to be mounted thereon, each of the first bus bar and the second bus bar of the resin molded bus bar preferably has an outer surface covered with the insulating resin, the first bus bar is preferably arranged between the main circuit board and the power supply board while being spaced apart by a second separation distance that is smaller than the air insulation distance from the power supply board in the lateral portion covered with the insulating resin, and the second bus bar is preferably arranged between the main circuit board and the power supply board while being spaced apart by a third separation distance that is smaller than the air insulation distance from the main circuit board in the lateral portion covered with the insulating resin. Accordingly, the first bus bar is arranged between the main circuit board and the power supply board while being spaced apart by the second separation distance that is smaller than the air insulation distance from the power supply board in the lateral portion covered with the insulating resin such that a distance between the first bus bar and the power supply board can be reduced. Furthermore, the second bus bar is arranged between the main circuit board and the power supply board while being spaced apart by the third separation distance that is smaller than the air insulation distance from the main circuit board in the lateral portion covered with the insulating resin such that a distance between the second bus bar and the main circuit board can be reduced. Consequently, a distance between the main circuit board and the power supply board arranged so as to sandwich the first bus bar and the second bus bar can be reduced, and thus an increase in the size in the upward-downward direction over the main circuit board can be significantly reduced or prevented.

In the aforementioned configuration including the power supply board, the first bus bar preferably includes a first main circuit board connector exposed from the insulating resin, the first main circuit board connector being connected to the main circuit board, and a power supply board connector exposed from the insulating resin, the power supply board connector being connected to the power supply board. Accordingly, the first bus bar having the outer surface covered with the insulating resin can be easily connected to the main circuit board by the first main circuit board connector exposed from the insulating resin. Furthermore, the first bus bar having the outer surface covered with the insulating resin can be easily connected to the power supply board by the power supply board connector exposed from the insulating resin.

In this case, the first bus bar preferably has a stepped shape that bends toward the main circuit board, the first main circuit board connector is preferably connected to the main circuit board from above, and the power supply board connector of the first bus bar preferably has a stepped shape that bends toward the power supply board, and is connected to the power supply board from below. Accordingly, even when the lateral portion in which the first bus bar is covered with the insulating resin is spaced apart from the main circuit board by the air insulation distance, due to the stepped shape of the first bus bar that bends toward the main circuit board, the first main circuit board connector of the first bus bar can be closer to the main circuit board (the height positions can be closer). Consequently, the first main circuit board connector of the first bus bar can be easily connected to the main circuit board. Furthermore, even when the lateral portion in which the first bus bar is covered with the insulating resin is spaced apart from the power supply board by the air insulation distance, due to the stepped shape of the power supply board connector that bends toward the power supply board, the power supply board connector can be closer to the power supply board (the height positions can be closer). Consequently, the power supply board connector of the first bus bar can be easily connected to the power supply board.

In the aforementioned power converter according to this aspect, the second bus bar preferably includes a second main circuit board connector exposed from the insulating resin, the second main circuit board connector being connected to the main circuit board, and the first bus bar is preferably arranged above the second bus bar in the lateral portion of the resin molded bus bar, and is preferably routed so as not to overlap the second main circuit board connector of the second bus bar, as viewed from above. Accordingly, even when the first bus bar is arranged above the second bus bar in the lateral portion of the resin molded bus bar, the second main circuit board connector of the second bus bar can be easily screwed (fastened) to the main circuit board from above.

In the aforementioned power converter according to this aspect, the vertical portion of the resin molded bus bar preferably has a thickness in a direction in which the first bus bar and the second bus bar overlap, the thickness decreasing upward from the lateral portion side. Accordingly, at the time of manufacturing the resin molded bus bar, the resin molded bus bar can be easily taken out from a casting mold.

The foregoing and other objects, features, aspects and advantages of the present invention will become more apparent from the following detailed description of the present invention when taken in conjunction with the accompanying drawings.

### BRIEF DESCRIPTION OF THE DRAWINGS

FIG. 1 is a diagram showing an example of the circuit configuration of a power converter according to an embodiment of the present invention;
FIG. 2 is a perspective view for illustrating the configuration of the power converter;
FIG. 3 is a perspective view for illustrating the configuration of a resin molded bus bar according to the embodiment of the present invention;
FIG. 4 is a diagram showing an arrangement of the resin molded bus bar, as viewed from above;
FIG. 5 is a partial sectional view taken along the line 200-200 in FIG. 4; and
FIG. 6 is a perspective view for illustrating the configuration of a resin molded bus bar according to a modified example.

### DESCRIPTION OF THE PREFERRED EMBODIMENTS

An embodiment of the present invention is hereinafter described with reference to the drawings.

### Overall Configuration of Power Converter

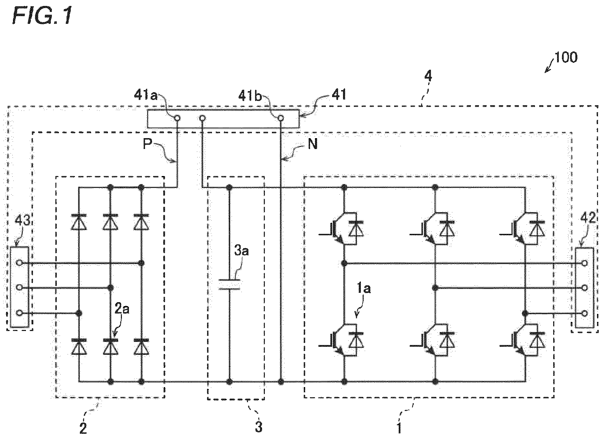

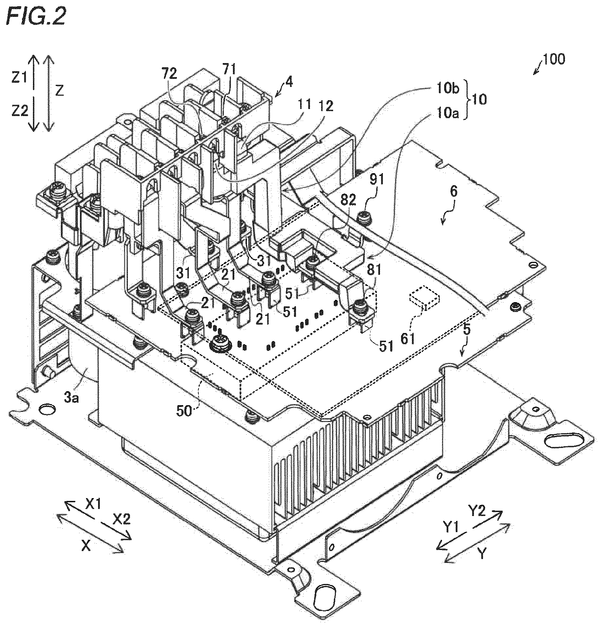

The overall configuration of a power converter 100 according to this embodiment is now described with reference to FIGS. 1 and 2. As shown in FIG. 1, the power converter 100 is an inverter including an inverter circuit 1 including switching elements 1a, a rectifier circuit 2 including diode elements 2a, and a smoothing circuit 3 including a smoothing capacitor 3a.

As shown in FIG. 1, the power converter 100 includes a terminal block 4 to which wiring is connected from outside the power converter. The terminal block 4 includes a DC terminal block 41. Furthermore, the terminal block 4 includes an output terminal block 42 and an input terminal block 43.

As shown in FIG. 2, the power converter 100 includes a main circuit board 5 on which a semiconductor module 50 is mounted. The semiconductor module 50 is an example of a "power conversion semiconductor module" in the claims. Power conversion semiconductor elements (the switching elements 1a and the diode elements 2a) are housed in the semiconductor module 50. The main circuit board 5 includes capacitors and relays (not shown).

As shown in FIG. 2, the power converter 100 includes a power supply board 6 arranged above (Z1 direction side) the main circuit board 5 and configured to allow an electronic component (component 61) configured to generate a control power supply to be mounted thereon. That is, a power supply for controlling a power conversion circuit (inverter circuit 1) is generated by the power supply board 6 and the electronic component mounted on the power supply board 6. Furthermore, electronic components that form a detection circuit (not shown) may be mounted on the power supply board 6.

The main circuit board 5 and the power supply board 6 are printed circuit boards (PCB) on which a wiring pattern is formed by conductors and electronic components are mounted. The main circuit board 5 and the power supply board 6 extend along an X direction and a Y direction (XY plane). In this description, an upward-downward direction is defined as a Z direction, a direction orthogonal to the upward-downward direction (Z direction) is defined as the X direction, and a direction orthogonal to the Z direction and the X direction is defined as the Y direction. In FIG. 2, only a portion of the power supply board 6 on the Y2 direction side is shown by a solid line, but in reality, the power supply board 6 extends to the vicinity of the end of the main circuit board 5 on the Y1 direction side, as shown by a broken line. The power supply board 6 covers the main circuit board 5 and a lateral portion 10a of a resin molded bus bar 10 described below.

As shown in FIG. 2, the semiconductor module 50 is mounted on the rear surface side (Z2 direction side) of the main circuit board 5. The main circuit board 5 includes a plurality of connection terminals 51 provided on the front surface side (Z1 direction side) of the main circuit board 5 to allow an electrical connection to the wiring pattern of the main circuit board 5 or the semiconductor module 50.

The power converter 100 includes output bus bars 21 connected to the output terminal block 42 (see FIG. 1) and input bus bars 31 connected to the input terminal block 43 (see FIG. 1). The output bus bars 21 and the input bus bars 31 are connected to the connection terminals 51 of the main circuit board 5, respectively.

As shown in FIG. 2, the terminal block 4 is arranged above (Z1 direction side) the main circuit board 5. The DC terminal block 41 and the output terminal block 42 are integrally formed. The terminal block 4 (the DC terminal block 41, the output terminal block 42, and the input terminal block 43) is made of a polybutylene terephthalate (PBT) resin, and includes a terminal for connecting to wiring outside the power converter.

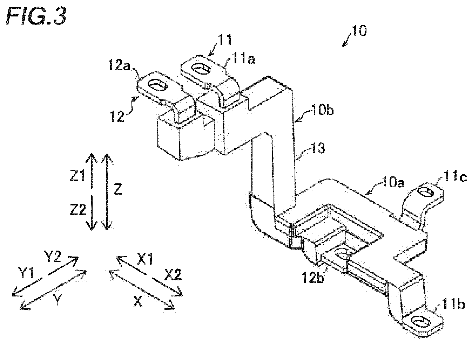

As shown in FIGS. 2 and 3, the power converter 100 includes the resin molded bus bar 10 integrally resin molded so as to insulate a plate-shaped first bus bar 11 and a plate-shaped second bus bar 12 with an insulating resin 13 (see FIG. 3).

As shown in FIGS. 2 and 3, the resin molded bus bar 10 has a substantially L-shape including the lateral portion 10a that extends along the main circuit board 5 and a vertical portion 10b that extends upward (Z1 direction side) from the lateral portion 10a toward the terminal block 4. The lateral portion 10a extends from the vertical portion 10b to the X2 direction side.

The first bus bar 11 and the second bus bar 12 are connected to the terminal block 4, as shown in FIG. 2. Furthermore, the first bus bar 11 and the second bus bar 12 are electrically connected to the main circuit board 5 (semiconductor module 50). In this embodiment, the first bus bar 11 and the second bus bar 12 are electrically connected to the semiconductor module 50 through the connection terminals 51 (see FIG. 2) of the main circuit board 5.

As shown in FIG. 3, the outer surfaces of the first bus bar 11 and the second bus bar 12 of the resin molded bus bar 10 are covered with the insulating resin 13. The insulating resin 13 is a PBT resin, for example. In the resin molded bus bar 10, the insulating resin 13 is also provided between the first bus bar 11 and the second bus bar 12, as described below.

The first bus bar 11 is a bus bar provided in a current path P (see FIG. 1) between the rectifier circuit 2 (diode element 2a) and a positive electrode terminal 41a (see FIG. 1) of the DC terminal block 41. The first bus bar 11 is a conductive plate-shaped member. The first bus bar 11 is a copper bar, for example.

As shown in FIG. 3, the first bus bar 11 includes a positive electrode connector 11a exposed from the insulating resin 13 and connected to the positive electrode terminal 41a (see FIG. 1) of the DC terminal block 41.

As shown in FIG. 3, the first bus bar 11 includes a connector 11b exposed from the insulating resin 13 and connected to the main circuit board 5. The connector 11b is an example of a "first main circuit board connector" in the claims.

As shown in FIG. 3, the first bus bar 11 includes a connector 11c exposed from the insulating resin 13 and connected to the power supply board 6. The connector 11c is an example of a "power supply board connector" in the claims.

The second bus bar 12 is a bus bar provided in a current path N (see FIG. 1) to connect the inverter circuit 1 (switching element 1a) and the smoothing circuit 3 (smoothing capacitor 3a) to a negative electrode terminal 41b (see FIG. 1) of the DC terminal block 41. The second bus bar 12 is a conductive plate-shaped member. The second bus bar 12 is a copper bar, for example.

As shown in FIG. 3, the second bus bar 12 includes a negative electrode connector 12a exposed from the insulating resin 13 and connected to the negative electrode terminal 41b (see FIG. 1) of the DC terminal block 41. The negative electrode connector 12a of the second bus bar 12 is arranged on the Y1 direction side with respect to the positive electrode connector 11a of the first bus bar 11.

As shown in FIG. 3, the second bus bar 12 includes a connector 12b exposed from the insulating resin 13 and connected to the main circuit board 5. The connector 12b is an example of a "second main circuit board connector" in the claims.

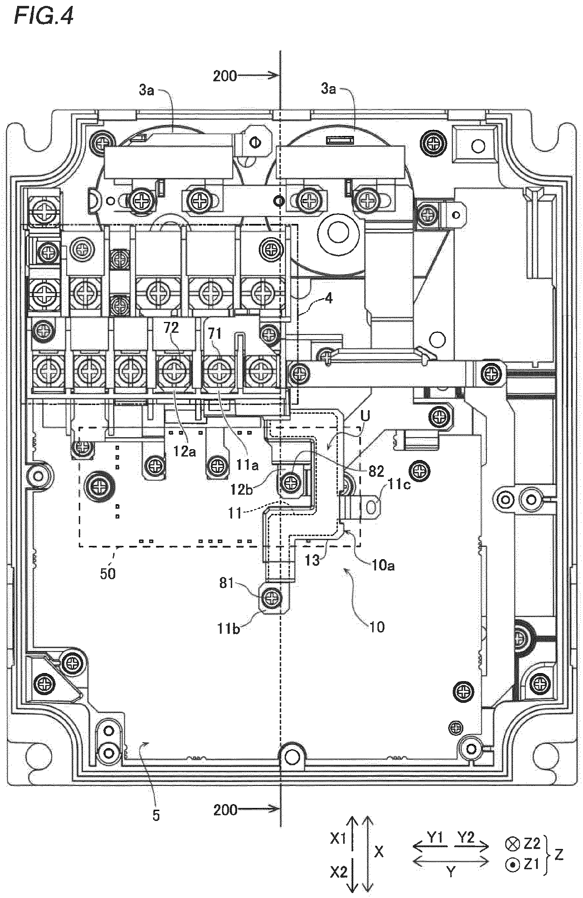

As shown in FIG. 4, the positive electrode connector 11a of the first bus bar 11 is fastened to the terminal block 4 (positive electrode terminal 41a) by a screw 71. Furthermore, as shown in FIG. 4, the negative electrode connector 12a of the second bus bar 12 is fastened to the terminal block 4 (negative electrode terminal 41b) by a screw 72.

As shown in FIG. 4, the connector 11b of the first bus bar 11 is arranged on the side (X2 direction side) opposite to the side on which the smoothing capacitor 3a is arranged with respect to the connector 12b of the second bus bar 12, as viewed from above (Z1 direction side).

As shown in FIG. 4, the first bus bar 11 is routed so as not to overlap the connector 12b of the second bus bar 12, as viewed from above (Z1 direction side).

As shown in FIG. 4, the resin molded bus bar 10 branches in the vicinity of the connector 12b of the second bus bar 12. The first bus bar 11 bends to the Y2 direction side with the outer surface covered with the insulating resin 13 on the X1 direction side of the connector 12b of the second bus bar 12. Furthermore, the first bus bar 11 is routed so as not to overlap the connector 12b of the second bus bar 12 and extends in an X2 direction.

As shown in FIG. 4, the first bus bar 11 with the outer surface with the insulating resin 13 has a U-shape that is convex to the Y2 direction side, as viewed from above (Z1 direction side). The connector 12b of the second bus bar 12 is arranged inside a substantially U-shaped portion (portion U) of the first bus bar 11, as viewed from above (Z1 direction side). The connector 11c extends from the outside (Y2 direction side) of the substantially U-shaped portion (portion U) of the first bus bar 11 to the Y2 direction side.

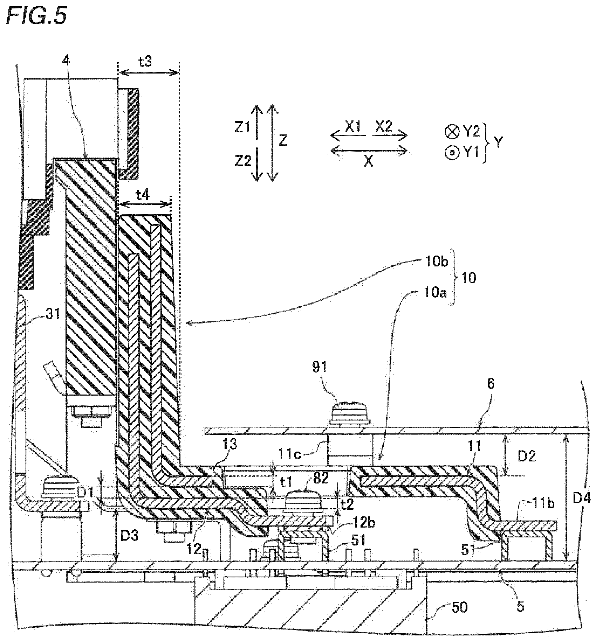

As shown in FIG. 5, the first bus bar 11 is arranged above (Z1 direction side) the second bus bar 12 in the lateral portion 10a of the resin molded bus bar 10. As shown in FIG. 5, the second bus bar 12 is arranged on the terminal block 4 side (X1 direction side) with respect to the first bus bar 11 in the vertical portion 10b of the resin molded bus bar 10.

As shown in FIG. 5, the resin molded bus bar 10 is configured to sandwich the insulating resin 13 between the first bus bar 11 and the second bus bar 12. The resin molded bus bar 10 sandwiches the insulating resin 13 between the first bus bar 11 and the second bus bar 12 in the lateral portion 10a and the vertical portion 10b. In the resin molded bus bar 10, the first bus bar 11 and the second bus bar 12 are stacked while being spaced apart from each other by a separation distance D1 (see FIG. 5) smaller than an air insulation distance. The separation distance D1 is an example of a "first separation distance" in the claims.

As described above, the first bus bar 11 is connected to the positive electrode terminal 41a (see FIG. 1) of the DC terminal block 41 by the positive electrode connector 11a. The second bus bar 12 is connected to the negative electrode terminal 41b (see FIG. 1) of the DC terminal block 41 by the negative electrode connector 12a. Currents flow through the first bus bar 11 and the second bus bar 12 in opposite directions to each other. In the vertical portion 10b and the lateral portion 10a of the resin molded bus bar 10, the first bus bar 11 and the second bus bar 12 are stacked. Thus, in portions of the vertical portion 10b and the lateral portion 10a in which the first bus bar 11 and the second bus bar 12 are stacked, currents flow through the first bus bar 11 and the second bus bar 12 in opposite directions to each other such that magnetic fields generated by the currents flowing through the first bus bar 11 and the second bus bar 12 can cancel each other out. Consequently, in the resin molded bus bar 10, the inductances of the first bus bar 11 and the second bus bar 12 can be reduced in the portions of the vertical portion 10b and the lateral portion 10a in which the first bus bar 11 and the second bus bar 12 are stacked.

The first bus bar 11 and the second bus bar 12 are spaced apart from each other by the separation distance D1 (see FIG. 5), but the separation distance D1 (the thickness of the insulating resin 13 between the first bus bar 11 and the second bus bar 12) may be changed as appropriate according to the magnitudes of the currents flowing through the first bus bar 11 and the second bus bar 12 and the electrical characteristics of the insulating resin 13. That is, the separation distance D1 (the thickness of the insulating resin 13 between the first bus bar 11 and the second bus bar 12) may be substantially the same as the thickness t1 of the first bus bar 11 and the thickness t2 of the second bus bar 12, as shown in FIG. 5, or may be larger or smaller than the thickness t1 of the first bus bar 11 and the thickness t2 of the second bus bar 12.

The first bus bar 11 is arranged between the circuit board 5 and the power supply board 6 while being spaced apart from the power supply board 6 by a separation distance D2 (see FIG. 5) that is smaller than the air insulation distance in the lateral portion 10a covered with the insulating resin 13. The separation distance D2 is an example of a "second separation distance" in the claims.

The first bus bar 11 has a stepped shape (see FIG. 5) that bends toward the main circuit board 5 (Z2 direction side), and the connector 11b is connected to the main circuit board 5 from above (Z1 direction side). The connector 11b of the first bus bar 11 is connected to the connection terminal 51 of the main circuit board 5 from the Z1 direction side by a screw 81 (see FIG. 4), and is electrically connected to the semiconductor module 50 through the connection terminal 51. The first bus bar 11 is electrically connected to the positive electrode side of the semiconductor module 50.

The connector 11c of the first bus bar 11 has a stepped shape (see FIGS. 3 and 5) that bends toward the power supply board 6 (Z1 direction side), and is connected to the power supply board 6 from below (Z2 direction side). The connector 11c is connected to the conductor pattern of the power supply board 6 from the Z2 direction side, and is fastened by a screw 91.

The second bus bar 12 is arranged between the main circuit board 5 and the power supply board 6 while being spaced apart from the main circuit board 5 by a separation distance D3 (see FIG. 5) that is smaller than the air insulation distance in the lateral portion 10a covered with the insulating resin 13. The separation distance D3 is an example of a "third separation distance" in the claims.

The second bus bar 12 has a stepped shape (see FIG. 5) that bends toward the main circuit board 5 (Z2 direction side), and the connector 12b is connected to the main circuit board 5 from above (Z1 direction side). As shown in FIG. 5, the connector 12b of the second bus bar 12 is connected to the connection terminal 51 of the main circuit board 5 from the Z1 direction side by a screw 82, and is electrically connected to the semiconductor module 50 through the connection terminal 51. The second bus bar 12 is electrically connected to the negative electrode side of the semiconductor module 50.

As shown in FIG. 5, the vertical portion 10b of the resin molded bus bar 10 is configured such that the thickness thereof in the X direction (a direction in which the first bus bar 11 and the second bus bar 12 overlap) decreases (tapers) upward (Z1 direction side) from the lateral portion 10a side (Z2 direction side). That is, in the resin molded bus bar 10, the thickness t4 of the vertical portion 10b on the upper side (Z1 direction side) is smaller than the thickness t3 of the vertical portion 10b on the lower side (Z2 direction side).

### Advantageous Effects of Embodiment

According to this embodiment, the following advantageous effects are achieved.

According to this embodiment, the resin molded bus bar 10 has an L-shape including the lateral portion 10a that extends along the main circuit board 5 and the vertical portion 10b that extends upward (Z1 direction side) from the lateral portion 10a toward the terminal block 4. Furthermore, the resin molded bus bar 10 is integrally resin molded such that the first bus bar 11 and the second bus bar 12 are insulated by the insulating resin 13. Accordingly, the insulating resin 13 insulates the first bus bar 11 from the second bus bar 12, and thus even when the first bus bar 11 and the second bus bar 12 overlap in the upward-downward direction (Z direction), a distance between the first bus bar 11 and the second bus bar 12 can be smaller in the lateral portion 10a that extends along the main circuit board 5 than that in a case in which insulation is provided by air (air insulation is provided). Consequently, an increase in the size of the power converter 100 in the upward-downward direction over the main circuit board 5 can be significantly reduced or prevented. Furthermore, the lateral portion 10a of the resin molded bus bar 10 including a single member in which the first bus bar 11, the second bus bar 12, and the insulating resin 13 are integrally resin molded extends along the main circuit board 5 such that both the first bus bar 11 and the second bus bar 12 can be easily electrically connected to the main circuit board 5 (semiconductor module 50). Furthermore, the vertical portion 10b of the resin molded bus bar 10 including a single member in which the first bus bar 11, the second bus bar 12, and the insulating resin 13 are integrally resin molded extends from the lateral portion 10a upward (Z1 direction side) toward the terminal block 4 such that both the first bus bar 11 and the second bus bar 12 can be easily electrically connected to the terminal block 4 arranged above the main circuit board 5. Accordingly, both the first bus bar 11 and the second bus bar 12 can be easily electrically connected to the main circuit board 5 (semiconductor module 50) and the terminal block 4 arranged above the main circuit board 5 by the resin molded bus bar 10 as a single member having an L-shape including the lateral portion 10a and the vertical portion 10b. Consequently, unlike a case in which the first bus bar 11 and the second bus bar 12 are attached so as to sandwich an insulating member as a separate member, an increase in the number of components and complication of assembly can be significantly reduced or prevented. Thus, an increase in the size of the power converter in the upward-downward direction can be significantly reduced or prevented while a decrease in workability during assembly is significantly reduced or prevented.

According to this embodiment, as described above, the resin molded bus bar 10 sandwiches the insulating resin 13 between the first bus bar 11 and the second bus bar 12, and the first bus bar 11 and the second bus bar 12 are stacked while being spaced apart from each other by the separation distance D1 that is smaller than the air insulation distance. Accordingly, even when the first bus bar 11 and the second bus bar 12 overlap in the upward-downward direction (Z direction), the insulating resin 13 is sandwiched between the first bus bar 11 and the second bus bar 12, and thus the first bus bar 11 and the second bus bar 12 can be reliably insulated. Consequently, the distance between the first bus bar 11 and the second bus bar 12 can be smaller than the air insulation distance, and thus an increase in the size of the power converter 100 in the upward-downward direction (Z direction) over the main circuit board 5 can be significantly reduced or prevented.

According to this embodiment, as described above, the first bus bar 11 includes the positive electrode connector 11a exposed from the insulating resin 13 and connected to the positive electrode terminal 41a of the DC terminal block 41. Furthermore, the second bus bar 12 includes the negative electrode connector 12a exposed from the insulating resin 13 and connected to the negative electrode terminal 41b of the DC terminal block 41. Moreover, the first bus bar 11 and the second bus bar 12 are configured to allow currents to flow therethrough in the opposite directions to each other. Accordingly, currents flow through the first bus bar 11 and the second bus bar 12 in the opposite directions such that the magnetic fields generated by the currents flowing through the first bus bar 11 and the second bus bar 12 can cancel each other out. Consequently, the inductances of the first bus bar 11 and the second bus bar 12 can be reduced.

According to this embodiment, as described above, the outer surfaces of the first bus bar 11 and the second bus bar 12 of the resin molded bus bar 10 are covered with the insulating resin 13. Furthermore, the first bus bar 11 is arranged between the main circuit board 5 and the power supply board 6 while being spaced apart by the separation distance D2 that is smaller than the air insulation distance from the power supply board 6 in the lateral portion 10a covered with the insulating resin 13. Moreover, the second bus bar 12 is arranged between the main circuit board 5 and the power supply board 6 while being spaced apart by the separation distance D3 that is smaller than the air insulation distance from the main circuit board 5 in the lateral portion 10a covered with the insulating resin 13. Accordingly, the first bus bar 11 is arranged between the main circuit board 5 and the power supply board 6 while being spaced apart by the separation distance D2 that is smaller than the air insulation distance from the power supply board 6 in the lateral portion 10a covered with the insulating resin 13 such that a distance between the first bus bar 11 and the power supply board 6 can be reduced. Furthermore, the second bus bar 12 is arranged between the main circuit board 5 and the power supply board 6 while being spaced apart by the separation distance D3 that is smaller than the air insulation distance from the main circuit board 5 in the lateral portion 10a covered with the insulating resin 13 such that a distance between the second bus bar 12 and the main circuit board 5 can be reduced. Consequently, a distance D4 (see FIG. 5) between the main circuit board 5 and the power supply board 6 arranged so as to sandwich the first bus bar 11 and the second bus bar 12 can be reduced, and thus an increase in the size in the upward-downward direction (Z direction) over the main circuit board 5 can be significantly reduced or prevented.

According to this embodiment, as described above, the first bus bar 11 includes the connector 11b exposed from the insulating resin 13 and connected to the main circuit board 5, and the connector 11c exposed from the insulating resin 13 and connected to the power supply board 6. Accordingly, the first bus bar 11 having the outer surface covered with the insulating resin 13 can be easily connected to the main circuit board 5 by the connector 11b exposed from the insulating resin 13. Furthermore, the first bus bar 11 having the outer surface covered with the insulating resin 13 can be easily connected to the power supply board 6 by the connector 11c exposed from the insulating resin 13.

According to this embodiment, as described above, the first bus bar 11 has a stepped shape that bends toward the main circuit board 5 (Z2 direction side), and the connector 11b is connected to the main circuit board 5 from above. Furthermore, the connector 11c of the first bus bar 11 has a stepped shape that bends toward the power supply board 6 (Z1 direction side), and is connected to the power supply board 6 from below. Accordingly, even when the lateral portion 10a in which the first bus bar 11 is covered with the insulating resin 13 is spaced apart from the main circuit board 5 by the air insulation distance, due to the stepped shape of the first bus bar 11 that bends toward the main circuit board 5, the connector 11b of the first bus bar 11 can be closer to the main circuit board 5 (Z2 direction side) (the height positions can be closer). Consequently, the connector 11b of the first bus bar 11 can be easily connected to the main circuit board 5. Furthermore, even when the lateral portion 10a in which the first bus bar 11 is covered with the insulating resin 13 is spaced apart from the power supply board 6 by the air insulation distance, due to the stepped shape of the connector 11c that bends toward the power supply board 6, the connector 11c can be closer to the power supply board 6 (Z1 direction side) (the height positions can be closer). Consequently, the connector 11c of the first bus bar 11 can be easily connected to the power supply board 6.

According to this embodiment, as described above, the second bus bar 12 includes the connector 12b exposed from the insulating resin 13 and connected to the main circuit board 5. Furthermore, the first bus bar 11 is arranged above the second bus bar 12 (Z1 direction side) in the lateral portion 10a of the resin molded bus bar 10, and is routed so as not to overlap the connector 12b of the second bus bar 12, as viewed from above. Accordingly, even when the first bus bar 11 is arranged above the second bus bar 12 in the lateral portion 10a of the resin molded bus bar 10, the connector 12b of the second bus bar 12 can be easily screwed (fastened) to the main circuit board 5 from above.

According to this embodiment, as described above, the vertical portion 10b of the resin molded bus bar 10 has a thickness in the direction (X direction) in which the first bus bar 11 and the second bus bar 12 overlap that decreases upward (Z1 direction side) from the lateral portion 10a side. Accordingly, at the time of manufacturing the resin molded bus bar 10, the resin molded bus bar 10 can be easily taken out from a casting mold.

### Modified Examples

The embodiment disclosed this time must be considered as illustrative in all points and not restrictive. The scope of the present invention is not shown by the above description of the embodiment but by the scope of claims for patent, and all modifications (modified examples) within the meaning and scope equivalent to the scope of claims for patent are further included.

For example, while the first bus bar 11 and the second bus bar 12 are connected to the terminal block 4, are connected to the connection terminals 51 of the main circuit board 5, and are electrically connected to the semiconductor module 50 through the connection terminals 51 of the main circuit board 5 in the aforementioned embodiment, the present invention is not restricted to this. For example, the first bus bar and the second bus bar may alternatively be connected to the terminal block and may be connected to terminals of the power conversion semiconductor module not through the main circuit board (the connection terminals of the main circuit board).

While in the resin molded bus bar 10, the first bus bar 11 and the second bus bar 12 (two bus bars) are integrally resin molded so as to be insulated by the insulating resin 13 in the aforementioned embodiment, the present invention is not restricted to this. In the present invention, the resin molded bus bar may alternatively include three or more bus bars integrally resin molded.

While in the resin molded bus bar 10, the first bus bar 11 connected to the positive electrode terminal 41a of the DC terminal block 41 and the second bus bar 12 connected to the negative electrode terminal 41b of the DC terminal block 41 are integrally resin molded in the aforementioned embodiment, the present invention is not restricted to this. In the present invention, in the resin molded bus bar, any two or more of the bus bar connected to the DC terminal block, the bus bar connected to the input terminal block, and the bus bar connected to the output terminal block may alternatively be integrally molded, or these bus bars may alternatively be combined and integrally molded. That is, the first bus bar may be any of the bus bar connected to the DC terminal block, the bus bar connected to the input terminal block, and the bus bar connected to the output terminal block. Furthermore, the second bus bar may be any of the bus bar connected to the DC terminal block, the bus bar connected to the input terminal block, and the bus bar connected to the output terminal block.

While the lateral portion 10a of the resin molded bus bar 10 is arranged between the main circuit board 5 and the power supply board 6 in the aforementioned embodiment, the present invention is not restricted to this. In the present invention, the power supply board may alternatively be shifted in a direction (the X direction or Y direction) along the main circuit board so as not to cover the upper side of the lateral portion of the resin molded bus bar.

While the first bus bar 11 includes the connector 11b (first main circuit board connector) exposed from the insulating resin 13 and connected to the main circuit board 5, and the connector 11c (power supply board connector) exposed from the insulating resin 13 and connected to the power supply board 6 in the aforementioned embodiment, the present invention is not restricted to this. In the present invention, the bus bar connected to the positive electrode terminal of the DC terminal block and connected to the power supply board may alternatively be provided separately from the resin molded first bus bar.

While the first bus bar 11 has a stepped shape that bends toward the main circuit board 5 (Z2 direction side), and the connector 11b (first main circuit board connector) is connected to the main circuit board 5 from above in the aforementioned embodiment, the present invention is not restricted to this. In the present invention, the connection terminal provided on the main circuit board may alternatively extend toward the first main circuit board connector of the first bus bar, and the first main circuit board connector of the first bus bar may alternatively be connected by the connection terminal provided on the main circuit board without bending toward the main circuit board.

While the connector 11c (power supply board connector) of the first bus bar 11 has a stepped shape that bends toward the power supply board 6 (Z1 direction side), and is connected to the power supply board 6 from below in the aforementioned embodiment, the present invention is not restricted to this. In the present invention, a connection terminal provided on the power supply board may alternatively extend toward the power supply board connector of the first bus bar, and the power supply board connector of the first bus bar may alternatively be connected by the connection terminal provided on the power supply board without bending toward the power supply board.

While the first bus bar 11 is arranged above (Z1 direction side) the second bus bar 12 in the lateral portion 10a of the resin molded bus bar 10 in the aforementioned embodiment, the present invention is not restricted to this. In the present invention, the first bus bar may alternatively be arranged below the second bus bar in the lateral portion of the resin molded bus bar.

While the first bus bar 11 connected to the positive electrode terminal 41a of the DC terminal block 41 is arranged above (Z1 direction side) the second bus bar 12 connected to the negative electrode terminal 41b of the DC terminal block 41 in the lateral portion 10a of the resin molded bus bar 10 in the aforementioned embodiment, the present invention is not restricted to this. In the present invention, the bus bar connected to the positive electrode terminal of the DC terminal block may alternatively be arranged below the bus bar connected to the negative electrode terminal of the DC terminal block in the lateral portion of the resin molded bus bar.

While the first bus bar 11 is covered with the insulating resin 13 up to the vicinity of the connection terminal 51 (see FIG. 5) in the aforementioned embodiment, the present invention is not restricted to this. In the present invention, the first bus bar may alternatively be exposed from the insulating resin in a portion of the resin molded bus bar in which a distance corresponding to the air insulation distance can be ensured (spaced apart) between the first bus bar and the power supply board. That is, the first bus bar may be covered with the insulating resin only in a portion of the resin molded bus bar in which a distance corresponding to the air insulation distance cannot be ensured (spaced apart) between the first bus bar and the power supply board. Alternatively, the second bus bar may alternatively be exposed from the insulating resin in a portion of the resin molded bus bar in which a distance corresponding to the air insulation distance can be ensured between the second bus bar and the main circuit board.

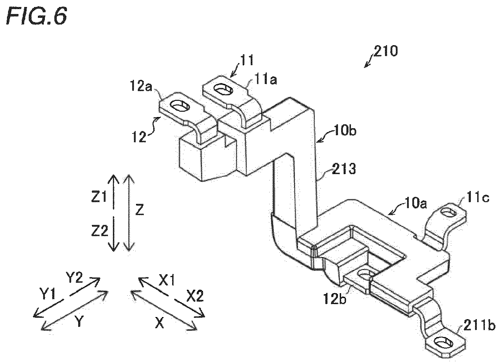

While the first bus bar 11 has a stepped shape that bends toward the main circuit board 5 (Z2 direction side) in the portion covered with the insulating resin 13, and the connector 11b (first main circuit board connector) exposed from the insulating resin 13 is connected to the main circuit board 5 from above (Z1 direction side) (see FIG. 5) in the aforementioned embodiment, the present invention is not restricted to this. In the present invention, the stepped portion of the first bus bar that bends toward the main circuit board may alternatively be exposed from the insulating resin. For example, as in a resin molded bus bar 210 according to a modified example shown in FIG. 6, a connector 211b (first main circuit board connector) exposed from an insulating resin 213 may have a stepped shape that bends toward a main circuit board 5 (see FIG. 5) (Z2 direction side). Thus, even when a lateral portion 10a in which a first bus bar 11 is covered with the insulating resin 213 is spaced apart from the main circuit board 5 (see FIG. 5) by an air insulation distance, due to the stepped shape of the connector 211b that bends toward the main circuit board 5 (Z2 direction side), the connector 211b can be closer to the main circuit board 5 (Z2 direction side) (the height positions can be closer). Consequently, the connector 211b of the first bus bar 11 can be easily connected to the main circuit board 5.

## Claims

1. A power converter (100) comprising:
a main circuit board (5) configured to allow a power conversion semiconductor module (50) to be mounted thereon;
a terminal block (4) arranged above the main circuit board, the terminal block being configured to allow wiring to be connected thereto from outside the power converter; and
a resin molded bus bar (10, 210) integrally resin molded such that a plate-shaped first bus bar (11) and a plate-shaped second bus bar (12), both of which are connected to the terminal block and are electrically connected to the main circuit board, are insulated by an insulating resin (13, 213); wherein
the resin molded bus bar has an L-shape including a lateral portion (10a) configured to extend along the main circuit board and a vertical portion (10b) configured to extend upward from the lateral portion toward the terminal block,
wherein the power converter (100) is **characterized by** further comprising
a power supply board (6) arranged above the main circuit board, the power supply board being configured to allow an electronic component (61) configured to generate a control power supply to be mounted thereon; wherein
each of the first bus bar and the second bus bar of the resin molded bus bar has an outer surface covered with the insulating resin;
the first bus bar is arranged between the main circuit board and the power supply board while being spaced apart by a second separation distance (D2) that is smaller than the air insulation distance from the power supply board in the lateral portion covered with the insulating resin; and
the second bus bar is arranged between the main circuit board and the power supply board while being spaced apart by a third separation distance (D3) that is smaller than the air insulation distance from the main circuit board in the lateral portion covered with the insulating resin,
wherein the first bus bar (11) and the second bus bar (12) are electrically connected to the semiconductor module (50) through connection terminals (51),
wherein the first bus bar includes a first main circuit board connector (11b, 211b) exposed from the insulating resin, the first main circuit board connector being connected to the main circuit board, and a power supply board connector (11c) exposed from the insulating resin, the power supply board connector being connected to the power supply board.

2. The power converter according to claim 1, wherein
the resin molded bus bar is configured to sandwich the insulating resin between the first bus bar and the second bus bar; and
the first bus bar and the second bus bar are stacked while being spaced apart from each other by a first separation distance (D1) that is smaller than an air insulation distance.

3. The power converter according to claim 1 or 2, wherein
the terminal block includes a DC terminal block (41);
the first bus bar includes a positive electrode connector (11a) exposed from the insulating resin, the positive electrode connector being connected to a positive electrode terminal (41a) of the DC terminal block;
the second bus bar includes a negative electrode connector (12a) exposed from the insulating resin, the negative electrode connector being connected to a negative electrode terminal (41b) of the DC terminal block; and
the first bus bar and the second bus bar are configured to allow currents to flow therethrough in opposite directions to each other.

4. The power converter according to claim 1, wherein
the first bus bar has a stepped shape that bends toward the main circuit board;
the first main circuit board connector is connected to the main circuit board from above; and
the power supply board connector of the first bus bar has a stepped shape that bends toward the power supply board, and is connected to the power supply board from below.

5. The power converter according to any one of claims 1 to 4, wherein
the second bus bar includes a second main circuit board connector (12b) exposed from the insulating resin, the second main circuit board connector being connected to the main circuit board; and
the first bus bar is arranged above the second bus bar in the lateral portion of the resin molded bus bar, and is routed so as not to overlap the second main circuit board connector of the second bus bar, as viewed from above.

6. The power converter according to any one of claims 1 to 5, wherein the vertical portion of the resin molded bus bar has a thickness in a direction in which the first bus bar and the second bus bar overlap, the thickness decreasing upward from the lateral portion side.

## Patentansprüche

1. Stromrichter (100), umfassend:
eine Hauptplatine (5), die konfiguriert ist, zu ermöglichen, dass darauf ein Stromrichterhalbleitermodul (50) angebracht werden kann;
einen Anschlussblock (4), der über der Hauptplatine angeordnet ist, wobei der Anschlussblock konfiguriert ist, zu ermöglichen, dass eine Verdrahtung von außerhalb des Stromrichters daran angeschlossen werden kann; und
eine harzgegossene Sammelschiene (10, 210), die ganzheitlich harzgegossen ist, sodass eine plattenförmige erste Sammelschiene (11) und eine plattenförmige zweite Sammelschiene (12), die beide mit dem Anschlussblock verbunden und mit der Hauptplatine elektrisch verbunden sind, durch ein Isolierharz (13, 213) isoliert sind; wobei
die harzgegossene Sammelschiene eine L-Form aufweist, die einen seitlichen Abschnitt (10a) umfasst, der konfiguriert ist, sich entlang der Hauptplatine zu erstrecken, und einen vertikalen Abschnitt (10b), der konfiguriert ist, sich von dem seitlichen Abschnitt nach oben in Richtung des Anschlussblocks zu erstrecken,
wobei der Stromrichter (100) **dadurch gekennzeichnet ist, dass** er ferner umfasst
eine Stromversorgungsplatine (6), die über der Hauptplatine angeordnet ist, wobei die Stromversorgungsplatine konfiguriert ist, zu ermöglichen, dass eine elektronische Komponente (61), die konfiguriert ist, eine Steuerstromversorgung zu erzeugen, darauf angebracht werden kann; wobei
sowohl die erste Sammelschiene als auch die zweite Sammelschiene der harzgegossenen Sammelschiene eine äußere Fläche aufweist, die mit dem Isolierharz abgedeckt ist;
die erste Sammelschiene zwischen der Hauptplatine und der Stromversorgungsplatine angeordnet ist, während sie durch einen zweiten Trennungsabstand (D2) beabstandet ist, der kleiner ist als der Luftisolationsabstand von der Stromversorgungsplatine in dem mit dem Isolierharz abgedeckten seitlichen Abschnitt; und
die zweite Sammelschiene zwischen der Hauptplatine und der Stromversorgungsplatine angeordnet ist, während sie durch einen dritten Trennungsabstand (D3) beabstandet ist, der kleiner ist als der Luftisolationsabstand von der Hauptplatine in dem mit dem Isolierharz abgedeckten seitlichen Abschnitt,
wobei die erste Sammelschiene (11) und die zweite Sammelschiene (12) über Verbindungsanschlüsse (51) mit dem Halbleitermodul (50) elektrisch verbunden sind,
wobei die erste Sammelschiene einen von dem Isolierharz freigelegten ersten Hauptplatinenverbinder (11b, 211b) umfasst, wobei der erste Hauptplatinenverbinder mit der Hauptplatine verbunden ist, und einen von dem Isolierharz freigelegten Stromversorgungsplatinenverbinder (11c), wobei der Stromversorgungsplatinenverbinder mit der Stromversorgungsplatine verbunden ist.

2. Stromrichter nach Anspruch 1, wobei
die harzgegossene Sammelschiene konfiguriert ist, das Isolierharz zwischen der ersten Sammelschiene und der zweiten Sammelschiene anzuordnen; und
die erste Sammelschiene und die zweite Sammelschiene gestapelt sind, während sie durch einen ersten Trennungsabstand (D1) voneinander beabstandet sind, der kleiner ist als ein Luftisolationsabstand.

3. Stromrichter nach Anspruch 1 oder 2, wobei
der Anschlussblock einen Gleichstromanschlussblock (41) umfasst;
die erste Sammelschiene einen von dem Isolierharz freigelegten Positivelektrodenverbinder (11a) umfasst, wobei der Positivelektrodenverbinder mit einem Positivelektrodenanschluss (41a) des Gleichstromanschlussblocks verbunden ist;
die zweite Sammelschiene einen von dem Isolierharz freigelegten Negativelektrodenverbinder (12a) umfasst, wobei der Negativelektrodenverbinder mit einem Negativelektrodenanschluss (41b) des Gleichstromanschlussblocks verbunden ist; und
die erste Sammelschiene und die zweite Sammelschiene konfiguriert sind, zu ermöglichen, dass Ströme in entgegengesetzten Richtungen zueinander durch sie hindurchfließen können.

4. Stromrichter nach Anspruch 1, wobei
die erste Sammelschiene eine Stufenform aufweist, die sich in Richtung der Hauptplatine biegt;
der erste Verbinder der Hauptplatine von oben mit der Hauptplatine verbunden ist; und
der Stromversorgungsplatinenverbinder der ersten Sammelschiene eine Stufenform aufweist, die sich in Richtung der Stromversorgungsplatine biegt, und von unten mit der Stromversorgungsplatine verbunden ist.

5. Stromrichter nach einem der Ansprüche 1 bis 4, wobei
die zweite Sammelschiene einen zweiten von dem Isolierharz freigelegten Hauptplatinenverbinder (12b) umfasst und der zweite Hauptplatinenverbinder mit der Hauptplatine verbunden ist; und
die erste Sammelschiene in dem seitlichen Abschnitt der harzgegossenen Sammelschiene über der zweiten Sammelschiene angeordnet und derart geführt ist, dass sie von oben gesehen den zweiten Hauptplatinenverbinder der zweiten Sammelschiene nicht überlappt.

6. Stromrichter nach einem der Ansprüche 1 bis 5, wobei der vertikale Abschnitt der harzgegossenen Sammelschiene eine Dicke in einer Richtung aufweist, in der sich die erste Sammelschiene und die zweite Sammelschiene überlappen, und die Dicke von der Seite des seitlichen Abschnitts nach oben hin abnimmt.

## Revendications

1. Convertisseur de puissance (100) comprenant :
une carte de circuit imprimé principale (5) configurée pour permettre à un module semi-conducteur de conversion de puissance (50) d'être monté sur celle-ci ;
un bornier (4) agencé au-dessus de la carte de circuit imprimé principale, le bornier étant configuré pour permettre au câblage d'être connecté à celui-ci depuis l'extérieur du convertisseur de puissance ; et
une barre bus moulée en résine (10, 210) moulée en résine d'un seul tenant de telle sorte qu'une première barre bus en forme de plaque (11) et qu'une deuxième barre bus en forme de plaque (12), toutes deux étant connectées au bornier et connectées électriquement à la carte de circuit imprimé principale, sont isolées par une résine isolante (13, 213) ;
dans lequel
la barre bus moulée en résine a une forme en L incluant une portion latérale (10a) configurée pour s'étendre le long de la carte de circuit imprimé principale et une portion verticale (10b) configurée pour s'étendre vers le haut à partir de la portion latérale vers le bornier,
dans lequel le convertisseur de puissance (100) est **caractérisé en ce qu'**il comprend en outre
une carte d'alimentation (6) agencée au-dessus de la carte de circuit imprimé principale, la carte d'alimentation étant configurée pour permettre à un composant électronique (61) configuré pour générer une alimentation de commande d'être monté sur celle-ci ; dans lequel
chacune de la première barre bus et de la deuxième barre bus de la barre bus moulée en résine a une surface externe recouverte avec la résine isolante ;
la première barre bus est agencée entre la carte de circuit imprimé principale et la carte d'alimentation tout en étant espacée d'une deuxième distance de séparation (D2) qui est inférieure à la distance d'isolation dans l'air de la carte d'alimentation dans la portion latérale recouverte avec la résine isolante ; et
la deuxième barre bus est agencée entre la carte de circuit imprimé principale et la carte d'alimentation tout en étant espacée d'une troisième distance de séparation (D3) qui est inférieure à la distance d'isolation dans l'air de la carte de circuit imprimé principale dans la portion latérale recouverte avec la résine isolante,
dans lequel la première barre bus (11) et la deuxième barre bus (12) sont électriquement connectées au module semi-conducteur (50) par l'intermédiaire de bornes de connexion (51),
dans lequel la première barre bus inclut un premier connecteur de carte de circuit imprimé principale (11b, 211b) exposé à partir de la résine isolante, le premier connecteur de carte de circuit imprimé principale étant connecté à la carte de circuit imprimé principale, et un connecteur de carte d'alimentation (11c) exposé à partir de la résine isolante, le connecteur de carte d'alimentation étant connecté à la carte d'alimentation.

2. Convertisseur de puissance selon la revendication 1, dans lequel
la barre bus moulée en résine est configurée pour prendre en sandwich la résine isolante entre la première barre bus et la deuxième barre bus ; et
la première barre bus et la deuxième barre bus sont empilées tout en étant espacées l'une de l'autre d'une première distance de séparation (D1) qui est inférieure à une distance d'isolation dans l'air.

3. Convertisseur de puissance selon la revendication 1 ou 2, dans lequel
le bornier inclut un bornier CC (41) ;
la première barre bus inclut un connecteur d'électrode positive (11a) exposé à partir de la résine isolante, le connecteur d'électrode positive étant connecté à une borne d'électrode positive (41a) du bornier CC ;
la deuxième barre bus inclut un connecteur d'électrode négative (12a) exposé à partir de la résine isolante, le connecteur d'électrode négative étant connecté à une borne d'électrode négative (41b) du bornier CC ; et
la première barre bus et la deuxième barre bus sont configurées pour permettre aux courants de s'écouler à travers elles dans des directions opposées l'une à l'autre.

4. Convertisseur de puissance selon la revendication 1, dans lequel
la première barre bus a une forme en escalier qui fléchit vers la carte de circuit imprimé principale ;
le premier connecteur de carte de circuit imprimé principale est connecté à la carte de circuit imprimé principale depuis le dessus ; et
le connecteur de carte d'alimentation de la première barre bus a une forme en escalier qui fléchit vers la carte d'alimentation, et est connecté à la carte d'alimentation depuis le dessous.

5. Convertisseur de puissance selon l'une quelconque des revendications 1 à 4, dans lequel
la deuxième barre bus inclut un deuxième connecteur de carte de circuit imprimé principale (12b) exposé à partir de la résine isolante, le deuxième connecteur de carte de circuit imprimé principale étant connecté à la carte de circuit imprimé principale ; et
la première barre bus est agencée au-dessus de la deuxième barre bus dans la portion latérale de la barre bus moulée en résine, et est dirigée de sorte à ne pas chevaucher le deuxième connecteur de carte de circuit imprimé principale de la deuxième barre bus, vu de dessus.

6. Convertisseur de puissance selon l'une quelconque des revendications 1 à 5, dans lequel la portion verticale de la barre bus moulée en résine a une épaisseur dans une direction dans laquelle la première barre bus et la deuxième barre bus se chevauchent, l'épaisseur diminuant vers le haut à partir du côté de portion latérale.
